# EUROPEAN PATENT SPECIFICATION

(11) **EP 3 823 428 B1**
(45) Date of publication and mention of the grant of the patent: **03.01.2024**
(21) Application number: 18926134.0
(22) Date of filing: 12.07.2018
(51) Int. Cl.: H05K 13/08

(54) **TEMPLATE CREATING DEVICE AND COMPONENT MOUNTING MACHINE**
SCHABLONENERSTELLUNGSVORRICHTUNG UND BAUTEILMONTAGEMASCHINE
DISPOSITIF DE CRÉATION DE GABARIT ET MACHINE DE MONTAGE DE COMPOSANT

(43) Date of publication of application: 19.05.2021
(73) Proprietor: Fuji Corporation, Chiryu-shi, Aichi 472-8686 (JP)
(72) Inventor: ESAKI Hirotake, Chiryu-shi, Aichi 472-8686 (JP); AMANO Masafumi, Chiryu-shi, Aichi 472-8686 (JP)
(74) Representative: Grünecker Patent- und Rechtsanwälte PartG mbB
(86) International application number: PCT/JP2018/026396
(87) International publication number: WO 2020/012621

(56) References cited:
- WO-A1-2016/006076
- WO-A1-2017/072908
- DE-T5-112015 006 707
- JP-A- H10 320 054
- JP-A- 2017 072 924
- US-A1- 2016 091 869

## Description

### Technical Field

The present specification relates to a template creating device configured to create a template for searching for the positions of electrode pads on a board, and a component mounting machine that uses the template so created.

### Background Art

Technology for mass producing circuit boards by applying board work to boards on which wiring is printed is widespread. A typical example of a board work machine for performing board work is a component mounting machine for performing mounting work of a component. Generally, in a component mounting machine, the precise position of a board is obtained by detecting a position mark attached to the board, and the component is mounted based on a mounting coordinate position. An example of technology related to the mounting coordinate position of a component is disclosed in Patent Literature 1.

A component mounting coordinate creating device disclosed in Patent Literature 1 has a pattern matching unit that searches for the mounting position of each component by using the electrode pad information of Gerber data, being used when creating a print mask, as electrode pad information of the circuit board and comparing this with the terminal information of part data for each component, and a calculation unit for calculating the mounting coordinate position of each component based on the pattern matching result. With this configuration, it is possible to automatically generate a mounting coordinate position for each component to be mounted on a circuit board even without CAD data for the circuit board design.

DE 11 2015 006707 T5 relates to a device for generating model data of an electronic component to be mounted on a printed circuit board. The model data includes data of a mounting reference point with respect to the printed circuit board. The mounting reference point is determined using image data of an electronic component, the image data comprising information about contact points on the circuit board overlapping the electronic component and information about a mounting position of the electronic component on the circuit board.

US 2016/091869 A1 relates to a placement apparatus for accurate fitting of a first placement partner with a second placement partner, for example arranging components on a substrate. Images of the placement partners or of the respective holding apparatuses are recorded. A position evaluation apparatus creates an output data from processing the images, yielding the visual image of the placement result to be expected.

WO 2016/006076 A1 & EP 3169146 A1 relate to a creation method, which automatically creates coordinate data of mounting positions of components on a circuit board. The method creates a component template image, which represents arrangements of the connecting sections based on shape data of a relevant component and matches the component template image to the pad arrangement image in a vicinity of relevant component identification information.

### Patent Literature

Patent Literature 1: JP-A-2012-69617

### Summary of the Invention

### Technical Problem

In Patent Literature 1, it is preferable to be able to automatically generate a mounting coordinate position by data processing even if there is no actual board or component. However, actual boards have individual differences in manufacturing, for example, positional deviations of position marks and variations in size. In addition, the actual board is clamped and warped at the time of positioning, or is heated and thermally deformed by a reflow machine at the time of double-sided mounting. Therefore, when performing mounting work depending only on the detection result of a position mark, there is a possibility that errors will occur in the actual mounting position of the component. The error of the mounting position often becomes a problem in components which require fine positional accuracy.

As a countermeasure to this, in addition to the position mark attached to the corner of a board (global mark), a component position mark (local mark) has been attached in the vicinity of the component for which fine positional accuracy is required. However, in this countermeasure, it is necessary to secure a space on the board to attach the component position mark. In addition, it is necessary to add the component position mark data and the component position mark detection operation to the production program for operating the component mounting machine.

It is an object of the present specification to provide a template creating device for creating a template capable of searching for a component mounting position with fine positional accuracy without attaching a component position mark to a board and to provide a component mounting machine that uses the created template.

### Solution to Problem

The invention is defined by the independent claim.

A template creating device of the present invention comprises:
an electrode information acquisition section configured to acquire electrode information, which is information on electrodes of a component to be mounted at a predetermined mounting position of a board positioned inside a component mounting machine;wherein the electrode information includes information on the shape, size, number,and arrangement of electrodes; and a template creating section configured to create a template for searching for the positions of electrode pads arranged at the mounting position of the board and to be connected to the electrodes based on the acquired electrode information;wherein the template comprises template elements, which correspond to selected electrode pads, wherein the number and arrangement of the template elements coincide with the number and arrangement of the selected electrode pads;the template has seek lines, which constitute a template element provided to each selected electrode pad, wherein each seek line is capable of being scanned for the edge of an electrode pad; and the seek lines are arranged around a rotational symmetry point, which corresponds to an assumed center position of the respective electrode pad.

Furthermore, a component mounting machine of the present invention comprises an imaging section configured to image at least the vicinity of the mounting position of the positioned board and acquire board image data; a search section configured to search for the positions of electrode pads while moving a template, created by the template creating device of any one of claims 1 to 7, with respect to the board image data to acquire a mounting coordinate position indicating the mounting position; and a mounting section configured to mount the component based on the acquired mounting coordinate position.

### Advantageous Effect of the Invention

The template creating device disclosed in this specification creates a template for searching for the position of electrode pads on a board based on electrode information of the electrode of the component. By using this template, the position of the electrode pads can be searched for each actual substrate. Therefore, error factors such as individual differences, warpage, and thermal deformation of the board are eliminated, and the mounting position of the component can be searched for with fine positional accuracy. In addition, the component mounting machine disclosed herein uses the created template to enhance the positional accuracy of the actual component mounting position.

### Brief Description of Drawings

[Fig. 1] A plan view schematically showing an example configuration of a component mounting machine of the embodiment.
[Fig. 2] A functional block diagram showing a functional configuration of a template creating device of the embodiment and a functional configuration relating to the use of the template of the component mounting machine of the embodiment.
[Fig. 3] A plan view schematically showing electrode information of a certain CSP component.
[Fig. 4] A diagram schematically showing a template created by a template creating section.
[Fig. 5] A diagram showing board image data acquired by an imaging section.
[Fig. 6] A diagram showing a situation in which a search section searches for the position of an electrode pad using a template.
[Fig. 7] A diagram showing a situation in which a search by the search section has been completed satisfactorily.
[Fig. 8] A plan view schematically showing a board of the prior art.
[Fig. 9] A diagram schematically showing another template created by the template creating section, which is not in accordance with the claimed invention

### Description of Embodiments

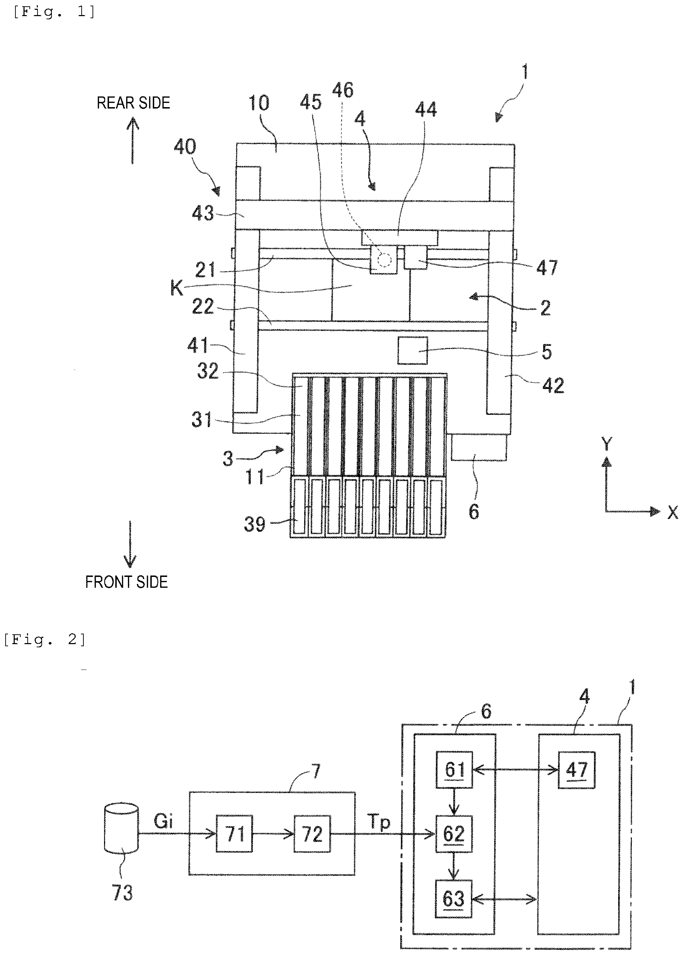

1. Example configuration of Component Mounting Machine 1 of the Embodiment First, an example configuration of component mounting device 1 of the embodiment using the template will be described. Fig. 1 is a plan view schematically showing an example configuration of component mounting machine 1 of the embodiment. Component mounting machine 1 performs a mounting operation of mounting a component onto board K. The direction from left to right in Fig. 1 in which board K is conveyed is the X-axis direction, and the direction from the bottom (front side) of the paper surface toward the top (rear side) is the Y-axis direction. Component mounting machine 1, board conveyance device 2, multiple tape feeders 3, component transfer device 4, part camera 5, control section 6, and the like are configured by assembling device table 10.

Board conveyance device 2 includes a pair of guide rails 21, 22, a pair of conveyor belts, a board clamping mechanism, and the like. By rolling along guide rails 21, 22 while board K is placed on top, conveyor belts convey board K to a work execution position. The board clamping mechanism pushes up board K at the work execution position to clamp and position board K. When the mounting work of components is completed, the board clamping mechanism releases board K, and the conveyor belts convey out board K.

Multiple tape feeders 3 are attached to multiple slots engraved in pallet member 11 on device table 10 and arranged side by side. Tape feeder 3 holds tape reel 39 at the front of main body section 31. Supply position 32 for supplying components is set at the upper portion of the rear vicinity of main body section 31. A carrier tape, accommodating components in each of many cavities, is wound around tape reel 39. Tape feeder 3 feeds the carrier tape to supply position 32 by a tape feeding mechanism (not shown) sequentially supplying components from the cavities.

Component transfer device 4 is disposed above board conveyance device 2 and tape feeder 3. Component transfer device 4 picks up components from tape feeder 3 and mounts components to board K. Component transfer device 4 includes head driving mechanism 40, mounting head 44, nozzle tool 45, suction nozzle 46, and mark camera 47. Head driving mechanism 40 is configured to include a pair of Y-axis rails 41, 42, Y-axis slider 43, and a drive motor (not shown). Y-axis rails 41, 42 extend in the Y-axis direction parallel to each other and are spaced apart from each other. Long Y-axis slider 43 in the X-axis direction is laid across both Y-axis rails 41, 42 and moves in the Y-axis direction. Mounting head 44 is installed on Y-axis slider 43 and moves in the X-axis direction. Head driving mechanism 40 drives Y-axis slider 43 in the Y-axis direction and drives mounting head 44 on Y-axis slider 43 in the X-axis direction.

Mounting head 44 holds nozzle tool 45 and mark camera 47. Nozzle tool 45 has one or multiple suction nozzles 46 on its lower side. Suction nozzle 46 is operated to move up and down by being driven by lifting and lowering drive section (not shown). Suction nozzle 46 moves downward from above supply position 32 and picks up components by a supply of negative pressure. There are multiple types of nozzle tool 45 and suction nozzle 46, which are replaced automatically or manually. By imaging a position mark attached to positioned board K, mark camera 47 detects an accurate work execution position of board K.

Component camera 5 is provided, facing upward, on the top face of device table 10, between board conveyance device 2 and tape feeder 3. Component camera 5 images the state of components picked up by suction nozzle 46 while mounting head 44 is in-transit from tape feeder 3 to board K. The acquired image data is subjected to image processing, and the suction orientation of the component is obtained as a result of the image processing. The image processing result is reflected in the next mounting operation of suction nozzle 46.

Control section 6 is attached to device table 10, and its installation position is not particularly limited. Control section 6 is configured by a computer device having a CPU and operated with software. Control section 6 may be configured by distributing multiple CPUs within the device. Control section 6 controls the mounting work of the component in accordance with a mounting sequence stored in advance.

### 2. Functional Configuration and Operation of Template Creating Device 7

Next, template creating device 7 of the embodiment will be described. Fig. 2 is a functional block diagram showing a functional configuration of template creating device 7 of the embodiment and a functional configuration relating to the use of the template of component mounting device 1 of the embodiment. In the present embodiment, template creating device 7 is configured separately from component mounting device 1. Template creating device 7 includes electrode information acquisition section 71 and template creating section 72.

Components targeted by template creating device 7 are limited to components in which fine positional accuracy is required in the mounting position. CSP components (Chip Size Package) and QFP components (Quad Flat Package) in which a large number of electrodes are arranged with a small pitch are examples of components requiring fine positional accuracy. For components outside of those targeted, component mounting machine 1 proceeds with mounting work according to the detection result of the work execution position of board K by mark camera 47. If all the components to be mounted on board K are targeted, the search using the template is applied to all the components, prolonging the mounting work.

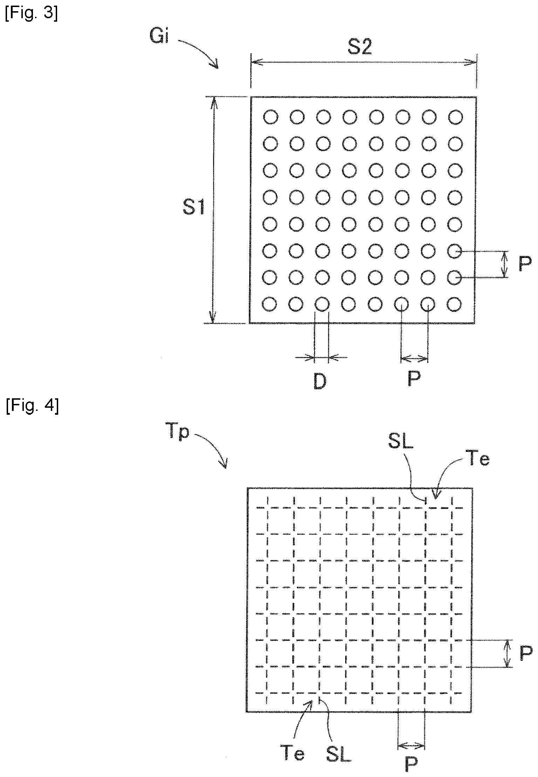

Electrode information acquisition section 71 acquires electrode information Gi, which is information related to the electrodes of target components. In the present embodiment, electrode information acquisition section 71 acquires electrode information Gi from shape data 73 of components stored in a database. Fig. 3 is a plan view schematically showing electrode information Gi of a certain CSP component. Electrode information Gi includes information on the shape, size, number, and arrangement of the electrodes.

In the example of Fig. 3, the shape of the electrode is a hemispherical shape called a ball grid and is circular in plan view. The size of the electrode is represented by a circle with diameter D. Further, there a total of 64 electrodes and the electrodes are arranged in a two-dimensional lattice of 8 electrodes in the vertical direction and 8 electrodes in the horizontal direction. Furthermore, the distance between the centers of the electrodes is arrangement pitch P in both the vertical and horizontal directions. Shape data 73 of the component also includes vertical dimension S1 and horizontal dimension S2 of the components.

Electrode information acquisition section 71 may acquire electrode information Gi by performing image processing on the image data obtained by imaging the CSP component. As a camera for imaging the CSP component, mark camera 47 of component mounting machine 1 or any other imaging device may be utilized. Further, electrode information acquisition section 71 may acquire electrode information Gi from measured data obtained from an actual measured physical quantity relating to the electrode of the CSP component. As a measuring instrument for actual measurement of a physical quantity, a three-dimensional scanner and various measuring techniques can be cited as examples. In the method of imaging CSP components and actual measurement of a physical quantity, it is possible to acquire accurate electrode information Gi using actual CSP components.

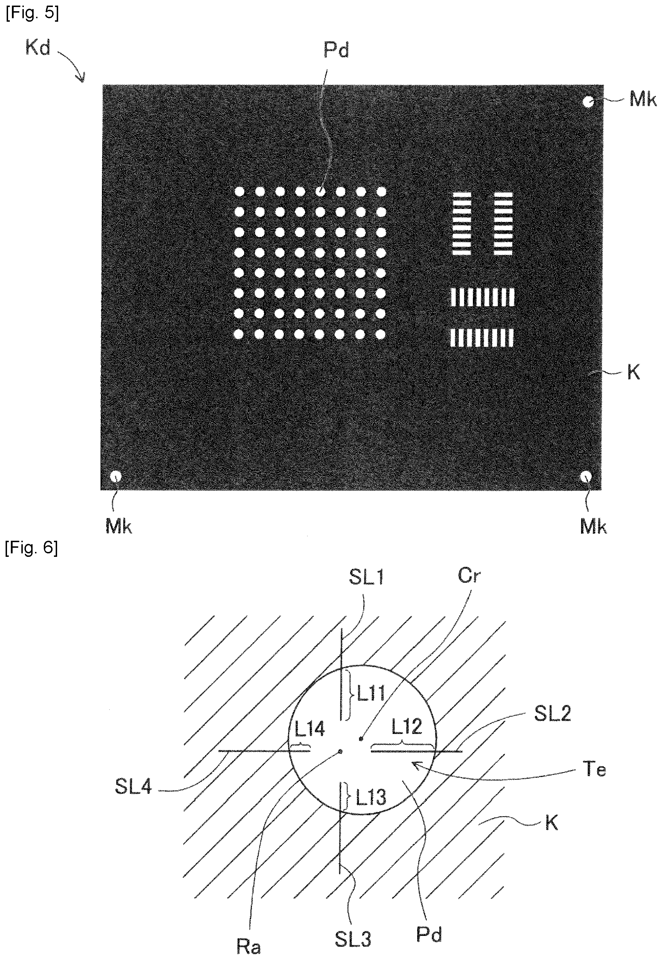

Template creating section 72 creates template Tp that searches for the position of electrode pads Pd (see Fig. 5) based on acquired electrode information Gi. Here, electrode pads Pd are arranged at mounting positions on board K and connected to electrodes of a CSP component by soldering. Usually, the number and arrangement of electrode pads Pd match the number and arrangement of electrodes. The size of electrode pad Pd is larger than the electrode. Furthermore, the shape of electrode pad Pd is in many cases the same as the shape of the electrode but may be different. For example, there are cases in which square electrode pads Pd are provided for circular electrodes.

The template Tp of the present invention has seek lines SL, which constitute template element Te provided to each electrode pad, and each seek line SL searches for the edge of electrode pad Pd. Fig. 4 is a diagram schematically showing template Tp created by template creating section 72. The outer square in Fig. 4 is shown with reference to the outline of the CSP component and is not included in template Tp.

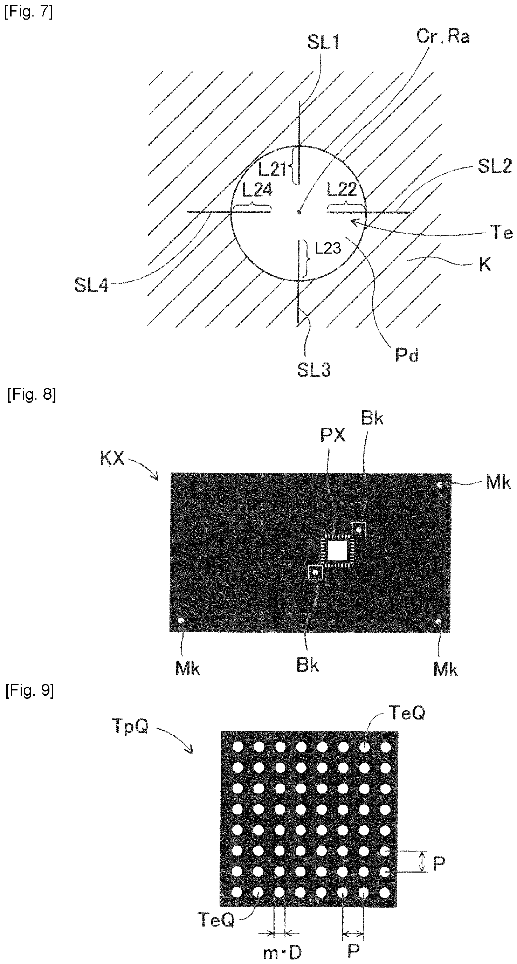

Template creating section 72 assumes that the number and arrangement of electrode pads Pd coincide with the number and arrangement of the electrodes. As a result, template creating section 72 can create 64 template elements Te corresponding to electrode pads Pd arranged in a two-dimensional lattice with arrangement pitch P. Each template element Te consists of four seek lines SLs arranged with a 90° pitch around rotational symmetry point Ra (see Figs. 6 and 7). Rotational symmetry point Ra corresponds to the assumed center position Cr of electrode pad Pd (see Figs. 6 and 7).

Here, although it is known in advance that electrode pad Pd has the same circular shape as the electrode, the exact size of electrode pad Pd is unknown. Therefore, template creating section 72 variably sets template element Te in consideration of the difference in size between the electrode and electrode pad Pd. That is, seek lines SL for searching for electrode pads Pd are set longer compared to seek lines corresponding to the size of the electrode.

In addition, when the shapes of the electrode and electrode pad Pd are different, template creating section 72 variably sets template element Te provided for each electrode pad Pd in consideration of the difference in the shapes of the electrode and electrode pad Pd. For example, when the electrode is circular and electrode pad Pd is a regular hexagon, template creating section 72 determines the arrangement of the center positions of electrode pads Pd based on electrode information Gi and sets template elements Te suitable for electrode pads Pd having a regular hexagon shape. Template element Te in this case consists of six seek lines arranged with a 60° pitch around rotational symmetry point Ra or three seek lines arranged with a 120° pitch around rotational symmetry point Ra. When electrode pad Pd is square, template element Te composed of four seek lines SL can be used in a shared manner.

Regarding the method of searching using seek lines SL, the applicant has disclosed the prior art in JP-A-8-180191 and JP-A-2017-72924. In the prior art, scanning is performed along seek lines SL and a position at which a pixel whose brightness changes greatly is determined to be an edge. That is, a position that changes from the low brightness of board K to the high brightness of electrode pad Pd or conversely a position that changes from high brightness to low brightness is detected to be an edge of electrode pad Pd.

In order to improve the accuracy of the search method described above, template creating section 72 changes the condition for using template Tp depending on whether paste-like solder is printed on electrode pads Pd of the actual board K. Specifically, template creating section 72 changes the threshold of brightness to distinguish between the material of board K and electrode pad Pd when scanning along seek line SL.

Additionally, electrode pad Pd has a high degree of brightness but approaches the low brightness of the material of board K when paste-like solder is printed. For this reason, it is fine to use a higher threshold value when paste-like solder is not printed, but a lower threshold value is necessary when paste-like solder is printed. If a higher threshold is used when paste-like solder is printed, there is a risk that electrode pads Pd may be mistaken, locally, for board K material, thereby reducing the accuracy of distinguishing the edge.

Template Tp created by template creating device 7 and the condition for using thereof are transferred to and used by component mounting device 1. Template creating device 7 of the embodiment creates template Tp for searching for the positions of electrode pads Pd on board K based on electrode information Gi of the electrodes of the CSP component. By using template Tp, the positions of electrode pads Pd can be searched for each actual board K. Therefore, error factors such as individual differences, warpage, and thermal deformation of board K are eliminated, and the mounting position of CSP components can be searched for with fine positional accuracy.

### 3. Functional Configuration and Operation Relating to the Use of Template Tp of Component Mounting Machine 1

Next, the functional configuration and the operation relating to the use of template Tp of component mounting device 1 of the embodiment will be described. As shown in Fig. 2, control section 6 of component mounting machine 1 has imaging section 61, search section 62, and mounting section 63.

Imaging section 61 is configured to include an imaging function of mark camera 47. Imaging section 61 causes mark camera 47 to image at least the vicinity of the mounting position of the positioned board K and acquires board image data Kd. The imaging area in the vicinity of the mounting position needs to include at least all electrode pads Pd to which the CSP component is mounted. If the imaging field of view of mark camera 47 is small with respect to the imaging area, imaging section 61 moves mark camera 47 to perform imaging multiple times. Further, imaging section 61 combines the multiple acquired image data to generate board image data Kd including the entire imaging region.

Further, imaging section 61 changes the imaging condition depending on whether paste-like solder is printed on electrode pads Pd. As described above, when paste-like solder is printed, the brightness of electrode pads Pd is reduced. Therefore, imaging section 61 changes the imaging condition so that electrode pads Pd printed with paste-like solder and the low brightness material of board K within board image data Kd are clearly distinguished from each other. Specifically, when paste-like solder is printed, imaging section 61 increases the light compared with the case in which paste-like solder is not printed or slows down the shutter speed.

Fig. 5 is a diagram showing board image data Kd acquired by imaging section 61. In the example of Fig. 5, board image data Kd including the entire surface of board K is obtained by synthesizing the image data described above. Further, imaging section 61 performs a black/white binarization process on the high/low brightness of board image data Kd. Thus, in board image data Kd, board K material is shown in black, and position marks Mk in the three corners of board K and electrode pads Pd are shown in white. In board image data Kd of Fig. 5, in addition to the 64 electrode pads Pd CSP component is to be connected to, there are 32 rectangular electrode pads for other components. Note that the binarization process is not essential, and board image data Kd may be raw data at the time of imaging in which each pixel has a different brightness value.

First, search section 62 receives template Tp from template creating device 7. Next, search section 62 searches for the positions of electrode pads Pd while moving template Tp with respect to board image data Kd. Fig. 6 is a diagram showing a situation in which search section 62 searches for the position of electrode pad Pd using template Tp. Further, Fig. 7 is a diagram showing a situation in which a search of search section 62 has been completed satisfactorily. In Figs. 6 and 7, the material of board K is indicated by hatching, and an image of one electrode pad Pd and one template element Te are shown.

In the present embodiment, since the exact size of electrode pad Pd is unknown, search section 62 cannot use the above-described prior art as it is. When search section 62 moves template Tp close to electrode pad Pd in board image data Kd, the situation shown in Fig. 6 occurs. In Fig. 6, all of four seek lines SL1, SL2, SL3, SL4 of template element Te intersect the edge of electrode pad Pd. Search section 62 obtains lengths L11, L12, L13, L14 of the portions where seek lines SL1, SL2, SL3, SL4 overlap electrode pad Pd.

Next, search section 62 compares the lengths of opposing seek lines to estimate center position Cr of electrode pad Pd. Specifically, length L11 of upper seek line SL1 in Fig. 6 is larger than length L13 of lower seek line SL3. Therefore, search section 62 estimates that center position Cr of electrode pad Pd is above rotational symmetry point Ra. Further, length L12 of right seek line SL2 is larger than length L14 of left seek line SL4. Therefore, search section 62 estimates that center position Cr of electrode pad Pd is on the right side of rotational symmetry point Ra.

Next, search section 62 moves template Tp to the upper right direction with respect to board image data Kd based on the estimation result. By repeating the estimation of center position Cr of electrode pad Pd and moving template Tp, the situation shown in Fig. 7 is obtained. It should be noted that it is also possible to estimate an appropriate moving distance to the upper right based on the difference (L11-L13) and the difference (L12-L14) in the length of seek lines SL1, SL2, SL3, SL4. This makes it possible to reduce the number of repetitions.

In Fig. 7, length L21 of upper seek line SL1 is equal to length L23 of lower seek line SL3. Length L22 of right seek line SL2 is equal to length L24 of left seek line SL4. At this juncture, center position Cr of electrode pad Pd overlaps rotational symmetry point Ra. Therefore, search section 62 can recognize that the search has been satisfactorily completed.

In practice, the situation shown in Fig. 7 does not always occur simultaneously in all 64 locations. In many cases, a position error occurs between center position Cr and rotational symmetry point Ra at multiple locations. Search section 62 acquires the mounting coordinate position representing the mounting position of the CSP component based on the position of template Tp in which the sum of the positional errors or the sum of the squares of the 64 positions is minimized.

Mounting section 63 is configured to include component transfer device 4. Mounting section 63 controls component transfer device 4 and causes component transfer device 4 to mount the CSP component to board K based on the mounting coordinate position obtained by search section 62. This increases the positional accuracy of the actual mounting position of the CSP component.

### 4. Comparison with Prior Art

Next, the effect of template creating device 7 and component mounting machine 1 of the embodiment on the circuit design of board K will be described in comparison with the prior art. Fig. 8 is a plan view schematically showing board KX of the prior art. In prior art board KX, position mark Mk is attached to each of the three corners. In addition, two component position marks Bk are attached to diagonal positions sandwiching multiple electrode pads PX arranged in a rectangle of a QFP component. In the prior art, it is necessary to secure a space for attaching component position mark Bk on board KX. Thus, the mounting density of components is limited and also affects the size of board KX when the number of target components is large.

In contrast, with template creating device 7 and component mounting machine 1 of the embodiment, component position mark Bk is not required. Therefore, the mounting density of the component is not limited, and there is no possibility for board KX to increase in size.

### 5. Applications and Modifications of the Embodiment

Template Tp of the claimed invention has seek lines SL. However, alternative configurations not being part of the claimed invention are also possible.

For example, template creating section 72 may create template TpQ shown in Fig. 9. Fig. 9 is a diagram schematically showing another template TpQ created by template creating section 72. In template TpQ, circular template element TeQ corresponding to the shape of electrode pad Pd is shown in white, and the portions corresponding to the material of board K are shown in black.

When creating template TpQ, the difference in size between the electrode and electrode pad Pd is taken into consideration, and diameter D of the electrode is multiplied by magnification m to obtain the diameter of template element TeQ. Magnification m is a value greater than 1 and is appropriately set with reference to the size of electrode pad Pd recommended by the component manufacturer. Magnification m is set larger than 1 because the dimension of electrode pad Pd of board K is usually larger than the dimension of the electrode of the component. Additionally, when a square electrode pad Pd is provided for a circular electrode, a square template element TeQ is required, considering the difference in the shape of the electrode and electrode pad Pd. Furthermore, the information on the number and the arrangement in electrode information Gi is used as is.

Note that it is not essential to set magnification m larger than 1. For example, it is assumed that electrode information acquisition section 71 of template creating device 7 captures an image of a CSP component, performs image processing on the obtained image data, and acquires electrode information Gi. In this case, under the influence of such a lighting angle at the time of imaging, the root portion of the hemispherical shape electrode shines, which makes it seem that diameter D is larger than the actual size. In consideration of this, magnification m may be set to 1 or less.

On the other hand, component mounting machine 1 uses template TpQ to perform a search by shape base matching. In detail, imaging section 61 performs a black/white binarization process on the high/low brightness of board image data Kd acquired by imaging. At this juncture, the imaging condition of imaging section 61 is changed depending on whether paste-like solder is printed on electrode pad Pd. The threshold of brightness for distinguishing between the inside of board and electrode pad Pd of board K is also changed depending on whether paste-like solder is printed on electrode pad Pd.

Next, search section 62 superimposes template TpQ on board image data Kd subjected to the binarization process, checks whether the white color and the black color regions match each other in each pixel and obtains the matching rate in the entire region of template TpQ. Next, search section 62 moves template TpQ with respect to board image data Kd and repeats the process of obtaining the matching rate. Finally, search section 62 acquires the mounting coordinate position representing the mounting position of the CSP component based on the position of template TpQ having the highest matching rate.

Further, although a detailed description is omitted, search section 62 can acquire not only the mounting coordinate position but also the mounting angle while considering the error of relative rotation in the horizontal plane of the CSP component. Also, the template (Tp, TpQ) need not have template elements (Te, TeQ) corresponding to the total number of electrodes. For example, it is possible to use only four template elements (Te, TeQ) corresponding to electrodes at four corners of the two-dimensional lattice arrangement shown in Fig. 3. Thus, the search time of search section 62 is reduced. Further, template creating device 7 is separate from component mounting machine 1 in the embodiment, but may be integrally formed in component mounting machine 1. Various other applications and modifications of the present embodiment are possible.

### Reference Signs List

1: Component mounting machine, 4: Component transfer device, 47: Mark camera, 6: Control device, 61: Imaging section, 62: Search section, 63: Mounting section, 7: Template creating device, 71: Electrode information acquisition section, 72: Template creating section, 73: Shape data, K: Board, Gi: Electrode information, Tp, TpQ: Template, Te, TeQ: Template element, SL, SL1, SL2, SL3, SL4: Seek line, Ra: Rotational symmetry point, Kd: Board image data, Pd: Electrode pad, Cr: Center position, Mk: Position mark, KX: Prior art board, Bk: Component position mark

## Claims

1. A template creating device (7), comprising:
an electrode information acquisition section (71) configured to acquire electrode information (Gi), which is information on electrodes of a component to be mounted at a predetermined mounting position of a board (K) positioned inside a component mounting machine (1);
wherein the electrode information (Gi) includes information on the shape, size, number, and arrangement of electrodes; and
a template creating section (72) configured to create a template (Tp, TpQ) for searching for the positions of electrode pads (Pd) arranged at the mounting position of the board (K) and to be connected to the electrodes based on the acquired electrode information (Gi);
wherein the template (Tp, TpQ) comprises template elements (Te, TeQ), which correspond to selected electrode pads, wherein the number and arrangement of the template elements (Te, TeQ) coincide with the number and arrangement of the selected electrode pads;
the template (Tp, TpQ) has seek lines (SL), which constitute a template element (Te, TeQ) provided to each selected electrode pad (Pd), and wherein each seek line (SL) is capable of being scanned for the edge of an electrode pad (Pd); and
the seek lines (SL) are arranged around a rotational symmetry point (Ra), which corresponds to an assumed center position (Cr) of the respective electrode pad (Pd).

2. The template creating device (7) of claim 1, wherein the electrode information acquisition section (71) is configured to acquire the electrode information (Gi) from the shape data (73) of the component.

3. The template creating device (7) of claim 1, wherein the electrode information acquisition section (71) is configured to acquire the electrode information (Gi) by image processing image data obtained by imaging the component.

4. The template creating device (7) of claim 1, wherein the electrode information acquisition section (71) is configured to acquire the electrode information (Gi) from actual measurement data obtained by actually measuring a physical quantity of the electrodes of the component.

5. The template creating device (7) of any one of claims 1 to 4, wherein the template creating section (72), in creating the template (Tp, TpQ), takes into consideration the difference in size between the electrodes and the electrode pads (Pd) and variably sets a template element (Te, TeQ) provided for each electrode pad (Pd).

6. The template creating device (7) of any one of claims 1 to 4, wherein the template creating section (72), in creating the template (Tp, TpQ), takes into consideration the difference in shape between the electrodes and the electrode pads (Pd) and variably sets a template element (Te, TeQ) provided for each electrode pad (Pd).

7. The template creating device (7) of any one of claims 1 to 6, wherein the template creating section (72) is configured to change a threshold of brightness for using the template (Tp, TpQ) depending on whether paste-like solder is printed on the electrode pads (Pd).

8. A component mounting machine (1), comprising:
an imaging section (61) configured to image at least the vicinity of the mounting position of the positioned board (K) and acquire board image data (Kd);
a search section (62) configured to search for the positions of electrode pads (Pd) while moving a template (Tp, TpQ), created by the template creating device (7) of any one of claims 1 to 7, with respect to the board image data (Kd) to acquire a mounting coordinate position indicating the mounting position; and
a mounting section (63) configured to mount the component based on the acquired mounting coordinate position.

9. The component mounting machine (1) of claim 8, wherein the imaging section (61) is configured to change the imaging condition depending on whether paste-like solder is printed on the electrode pads (Pd).

## Patentansprüche

1. Vorrichtung (7) zum Erstellen einer Schablone, die umfasst:
einen Abschnitt (71) für Erfassung von Elektroden-Informationen, der so konfiguriert ist, dass er Elektroden-Informationen (Gi) erfasst, die Informationen über Elektroden eines Bauteils sind, das an einer vorgegebenen Montageposition einer im Inneren einer Maschine (1) zum Montieren von Bauteilen positionierten Platine (K) montiert werden soll;
wobei die Elektroden-Informationen (Gi) Informationen über die Form, die Größe, die Anzahl sowie die Anordnung der Elektroden einschließen; und
einen Abschnitt (72) zum Erstellen einer Schablone, der so konfiguriert ist, dass er eine Schablone (Tp, TpQ) zum Suchen nach den Positionen von Elektroden-Anschlussflächen (Pd), die an der Montageposition der Platine (K) angeordnet sind und mit den Elektroden verbunden werden sollen, auf Basis der erfassten Elektroden-Informationen (Gi) erstellt;
wobei die Schablone (Tp, TpQ) Schablonen-Elemente (Te, TeQ) umfasst, die ausgewählten Elektroden-Anschlussflächen entsprechen, wobei die Anzahl und die Anordnung der Schablonen-Elemente (Te, TeQ) mit der Anzahl und der Anordnung der ausgewählten Elektroden-Anschlussflächen übereinstimmen;
die Schablone (Tp, TpQ) Suchlinien (SL) aufweist, die ein Schablonen-Element (Te, TeQ) bilden, das für jede ausgewählte Elektroden-Anschlussfläche (Pd) vorhanden ist, und wobei jede Suchlinie (SL) nach dem Rand einer Elektroden-Anschlussfläche (Pd) abgetastet werden kann; und
die Suchlinien (SL) um einen Rotationssymmetrie-Punkt (Ra) herum angeordnet sind, der einer angenommenen Mittelposition (Cr) der jeweiligen Elektroden-Anschlussfläche (Pd) entspricht.

2. Vorrichtung (7) zum Erstellen einer Schablone nach Anspruch 1, wobei der Abschnitt (71) für Erfassung von Elektroden-Informationen so konfiguriert ist, dass er die Elektroden-Informationen (Gi) anhand der Form-Daten (73) des Bauteils erfasst.

3. Vorrichtung (7) zum Erstellen einer Schablone nach Anspruch 1, wobei der Abschnitt (71) für Erfassung von Elektroden-Informationen so konfiguriert ist, dass er die Elektroden-Informationen (Gi) durch Bildverarbeitung durch Erzeugen eines Bildes des Bauteils gewonnener Bilddaten erfasst.

4. Vorrichtung (7) zum Erstellen einer Schablone nach Anspruch 1, wobei der Abschnitt (71) für Erfassung von Elektroden-Informationen so konfiguriert ist, dass er die Elektroden-Informationen (Gi) anhand tatsächlicher Messungs-Daten erfasst, die durch tatsächliches Messen einer physikalischen Größe der Elektroden des Bauteils gewonnen werden.

5. Vorrichtung (7) zum Erstellen einer Schablone nach einem der Ansprüche 1 bis 4, wobei der Abschnitt (72) zum Erstellen einer Schablone beim Erstellen der Schablone (Tp, TpQ) den Größenunterschied zwischen den Elektroden und den Elektroden-Anschlussflächen (Pd) berücksichtigt und ein für jede Elektroden-Anschlussfläche (Pd) vorhandenes Schablonen-Element (Te, TeQ) variabel einstellt.

6. Vorrichtung (7) zum Erstellen einer Schablone nach einem der Ansprüche 1 bis 4, wobei der Abschnitt (72) zum Erstellen einer Schablone beim Erstellen der Schablone (Tp, TpQ) den Formunterschied zwischen den Elektroden und den Elektroden-Anschlussflächen (Pd) berücksichtigt und ein für jede Elektroden-Anschlussfläche (Pd) vorhandenes Schablonen-Element (Te, TeQ) variabel einstellt.

7. Vorrichtung (7) zum Erstellen einer Schablone nach einem der Ansprüche 1 bis 6, wobei der Abschnitt (72) zum Erstellen einer Schablone so konfiguriert ist, dass er einen Schwellenwert von Helligkeit zum Einsetzen der Schablone (Tp, TpQ) in Abhängigkeit davon ändert, ob pastenartiges Lot auf die Elektroden-Anschlussflächen (Pd) gedruckt wird.

8. Maschine (1) zum Montieren von Bauteilen, die umfasst:
einen Bilderzeugungsabschnitt (61), der so konfiguriert ist, dass er ein Bild wenigstens der näheren Umgebung der Montageposition der positionierten Platte (K) erzeugt und Platinen-Bilddaten (Kd) erfasst;
einen Suchabschnitt (62), der so konfiguriert ist, dass er nach den Positionen von Elektroden-Anschlussflächen (Pd) sucht, während er eine von der Vorrichtung (7) zum Erstellen einer Schablone nach einem der Ansprüche 1 bis 7 erzeugte Schablone (Tp, TpQ) in Bezug auf die Platinen-Bilddaten (Kd) bewegt, um eine Montage-Koordinatenposition zu erfassen, die die Montageposition angibt; sowie
einen Montageabschnitt (63), der so konfiguriert ist, dass er das Bauteil auf Basis der erfassten Montage-Koordinatenposition montiert.

9. Maschine (1) zum Montieren von Bauteilen nach Anspruch 8, wobei der Bilderzeugungsabschnitt (61) so konfiguriert ist, dass er die Bilderzeugungs-Bedingung in Abhängigkeit davon ändert, ob pastenartiges Lot auf die Elektroden-Anschlussflächen (Pd) gedruckt wird.

## Revendications

1. Dispositif de création de gabarit (7), comprenant :
une section d'acquisition d'informations sur les électrodes (71) configurée pour acquérir des informations sur les électrodes (Gi), qui sont des informations sur les électrodes d'un composant à monter à une position de montage prédéterminée d'une carte (K) positionnée à l'intérieur d'une machine de montage de composants (1) ;
dans laquelle les informations sur les électrodes (Gi) comprennent des informations sur la forme, la taille, le nombre et la disposition des électrodes ; et
une section de création de modèle (72) configurée pour créer un modèle (Tp, TpQ) pour la recherche des positions des électrodes (Pd) disposées à la position de montage de la carte (K) et devant être connectées aux électrodes sur la base des informations acquises sur les électrodes (Gi) ;
dans lequel le gabarit (Tp, TpQ) comprend des éléments de gabarit (Te, TeQ) qui correspondent aux électrodes sélectionnées, le nombre et la disposition des éléments de gabarit (Te, TeQ) coïncidant avec le nombre et la disposition des électrodes sélectionnées ;
le gabarit (Tp, TpQ) comporte des lignes de recherche (SL), qui constituent un élément de gabarit (Te, TeQ) fourni à chaque plot d'électrode sélectionné (Pd), et dans lequel chaque ligne de recherche (SL) peut être scannée pour le bord d'un plot d'électrode (Pd) ; et
les lignes de recherche (SL) sont disposées autour d'un point de symétrie de rotation (Ra), qui correspond à une position centrale supposée (Cr) de la pastille d'électrode respective (Pd).

2. Dispositif de création de gabarit (7) selon la revendication 1, dans lequel la section d'acquisition des informations d'électrode (71) est configurée pour acquérir les informations d'électrode (Gi) à partir des données de forme (73) du composant.

3. Dispositif de création de gabarit (7) selon la revendication 1, dans lequel la section d'acquisition d'informations sur les électrodes (71) est configurée pour acquérir les informations sur les électrodes (Gi) par traitement d'image des données d'image obtenues par imagerie du composant.

4. Dispositif de création de gabarit (7) selon la revendication 1, dans lequel la section d'acquisition d'informations sur les électrodes (71) est configurée pour acquérir les informations sur les électrodes (Gi) à partir de données de mesure réelles obtenues en mesurant réellement une quantité physique des électrodes du composant.

5. Dispositif de création de gabarit (7) selon l'une des revendications 1 à 4, dans lequel la section de création de gabarit (72), en créant le gabarit (Tp, TpQ), prend en considération la différence de taille entre les électrodes et les patins d'électrodes (Pd) et définit de manière variable un élément de gabarit (Te, TeQ) prévu pour chaque patin d'électrode (Pd).

6. Dispositif de création de gabarit (7) selon l'une des revendications 1 à 4, dans lequel la section de création de gabarit (72), en créant le gabarit (Tp, TpQ), prend en considération la différence de forme entre les électrodes et les électrodes (Pd) et définit de manière variable un élément de gabarit (Te, TeQ) fourni pour chaque électrode (Pd).

7. Dispositif de création de gabarit (7) selon l'une des revendications 1 à 6, dans lequel la section de création de gabarits (72) est configurée pour modifier un seuil de luminosité pour l'utilisation du gabarit (Tp, TpQ) selon que de la soudure en pâte est imprimée sur les patins d'électrodes (Pd).

8. Machine de montage de composant (1), comprenant :
une section d'imagerie (61) configurée pour prendre des images au moins à proximité de la position de montage de la carte positionnée (K) et acquérir des données d'image de la carte (Kd) ;
une section de recherche (62) configurée pour rechercher les positions des électrodes (Pd) tout en déplaçant un gabarit (Tp, TpQ), créé par le dispositif de création de gabarit (7) de l'une quelconque des revendications 1 à 7, par rapport à la position de montage de la carte (K) selon l'une quelconque des revendications 1 à 7, par rapport aux données d'image de la carte (Kd) afin d'acquérir une position de coordonnées de montage indiquant la position de montage ; et
une section de montage (63) configurée pour monter le composant sur la base de la position de coordonnées de montage acquise.

9. Machine de montage de composant (1) selon la revendication 8, dans laquelle la section d'imagerie (61) est configurée pour modifier la condition d'imagerie selon que la soudure en pâte est imprimée sur les électrodes (Pd).
